# EUROPÄISCHE PATENTANMELDUNG

(11) **EP 0 906 006 A2**
(43) Veröffentlichungstag der Anmeldung: **31.03.1999**
(21) Anmeldenummer: 98116153.2
(22) Anmeldetag: 27.08.1998
(51) Int. Cl.: H05K 3/40, H01L 21/48

(54) **Verfahren zur Herstellung druckdichter Durchkontaktierungen**

(30) Priorität: 24.09.1997 DE 19742072
(71) Anmelder: ROBERT BOSCH GMBH, 70442 Stuttgart (DE)
(72) Erfinder: Moser, Manfred, 72768 Reutlingen-Sickenhausen (DE); Seibold, Annette, 71277 Rutesheim (DE); Schuetz, Reiner, 71254 Ditzingen (DE)

(57) **Zusammenfassung**

Die Erfindung betrifft ein Verfahren zur Herstellung druckdichter Durchkontaktierungen in Substraten, insbesondere in keramischen Dünnschichten, wobei die Durchkontaktierungen in das Substrat nachträglich eingebracht werden, indem das Substrat mit Durchgangsöffnungen versehen wird.

Es ist vorgesehen, daß die Durchgangsöffnungen (20) mit einer elektrisch leitfähigen Paste (22) vollständig gefüllt werden, und die Paste (22) anschließend dicht ausgehärtet wird.

## Beschreibung

Die Erfindung betrifft ein Verfahren zur Herstellung druckdichter Durchkontaktierungen, insbesondere in keramischen Dünnschichten, mit den im Oberbegriff des Anspruchs 1 genannten Merkmalen.

### Stand der Technik

Es ist bekannt, für Schaltungsanordnungen Substrate als Träger zu verwenden, die beidseitig miteinander zu verbindende elektrische Bauelemente aufweisen. Zur Realisierung dieser elektrisch leitenden Verbindungen ist bekannt, Durchkontaktierungen vorzusehen, bei denen das Substrat mit einer Öffnung versehen wird, deren Mantelfläche mit einer elektrisch leitenden Beschichtung überzogen wird. Sollen derartige Durchkontaktierungen aufweisende Substrate beispielsweise in der Avionik eingesetzt werden, ist es erforderlich, daß druckdichte Durchkontaktierungen zur Verfügung stehen müssen.

### Vorteile der Erfindung

Das erfindungsgemäße Verfahren mit den im Anspruch 1 genannten Merkmalen bietet den Vorteil, daß in einfacher Weise druckdichte elektrisch leitende Durchkontaktierungen herstellbar sind. Dadurch, daß die Öffnungen der Durchkontaktierungen mit einer elektrisch leitfähigen Paste vollständig gefüllt werden, und die Paste dicht ausgehärtet wird, kann sehr vorteilhaft, über die elektrisch leitfähige Paste, die elektrisch leitende Verbindung realisiert werden, während die ausgehärtete Paste gleichzeitig das Volumen vollständig der Durchgangsöffnung ausfüllt, so daß eine hermetische Abdichtung zwischen Ober- und Unterseite der die Durchkontaktierung aufweisenden Substrate möglich ist.

Vorteilhafte Ausgestaltungen der Erfindung ergeben sich aus den in den Unteransprüchen genannten Merkmalen.

### Zeichnungen

Die Erfindung wird nachfolgend in Ausführungsbeispielen anhand der zugehörigen Zeichnungen näher erläutert. Es zeigen:

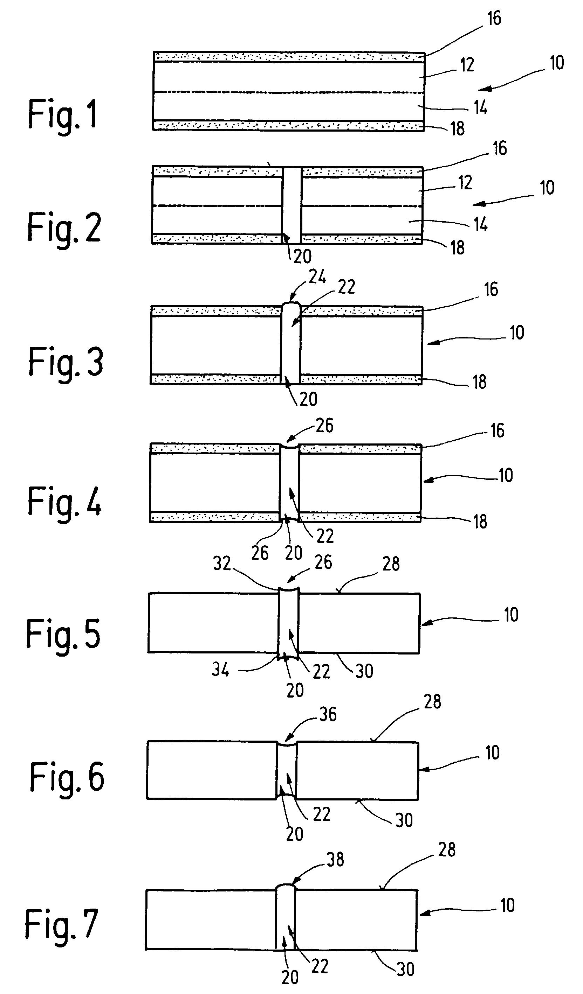

- Figur 1 bis Figur 7: Verfahrensschritte zur Herstellung druckdichter Durchkontaktierungen in einer Dünnschichtkeramik.

### Beschreibung der Ausführungsbeispiele

Figur 1 zeigt ein Substrat 10, das aus zwei übereinander angeordneten Folien 12 und 14 gebildet ist. Die Folien 12 und 14 sind beispielsweise LTCC (Low temperature cofiring ceramic) -Folien, die beispielsweise aus Aluminiumoxid Al₂O₃ und Glas als Sinterhilfsmittel bestehen. Derartige keramische Folien werden beispielsweise in hochfrequenztauglichen Schaltungen, bei denen Frequenzen bis circa 20 GHz auftreten können, verwendet. Die Folien 12 und 14 liegen als sogenannte grüne Folien vor, das heißt, das die Folien 12 und 14 ergebende Material wird durch bekannte Laminierungsprozesse, beispielsweise durch Druck und/oder Temperatur, übereinander im Rohzustand des Materials angeordnet. Zudem können zwischen den Folien 12 und 14 Leiterbahnen und Masseebenen, beispielsweise durch Sieb- und Schablonendruck, aufgebracht werden. Die Ober- und/oder Unterseite des Substrates 10, im gezeigten Beispiel beide Seiten, werden mit einer Hilfsfolie 16 beziehungsweise 18 versehen. Die Hilfsfolien 16 und 18 bestehen beispielsweise aus PET und können beispielsweise auf das Substrat 10 aufgerollt werden.

Eine weitere Möglichkeit ist, die keramische Folie bei der Herstellung auf die Folie 16 beziehungsweise 18 zu gießen.

In den derart vorbereiteten Laminatverbund, wie in Figur 1 gezeigt ist, werden gemäß Figur 2 Durchgangsöffnungen 20 eingebracht. Die Durchgangsöffnungen 20 dienen der späteren Herstellung einer Durchkontaktierung. In dem gezeigten Ausführungsbeispiel ist lediglich die Herstellung einer Durchkontaktierung dargestellt, wobei klar ist, daß mittels des Verfahrens gleichzeitig eine Vielzahl von Durchkontaktierungen herstellbar sind.

Die Durchgangsöffnung 20 kann beispielsweise mittels Stanzen, Bohren oder anderen geeigneten Verfahren eingebracht werden.

Gemäß Figur 3 werden die Durchgangsöffnungen 20 mit einer elektrisch leitfähigen Paste 22 gefüllt. Als elektrisch leitfähige Paste 22 kann beispielsweise eine Silber-Palladiumpaste, eine Silberpaste, eine Goldpaste oder andere an sich bekannte Leitpasten eingesetzt werden. Das Einbringen der Leitpaste 22 in die Durchgangsöffnungen 20 erfolgt beispielsweise mittels eines Druckschrittes, wobei ein Schablonendruck oder ein Siebdruck eingesetzt werden kann. Hierbei ist an der Oberseite der Folie 16 eine entsprechende Schablone angeordnet, die das Einbringen der Paste 22 in die Durchgangsöffnungen 20 gestattet. Im Bereich der Folie 16 ergibt sich durch das Einbringen der Paste 22 und den auftretenden Grenzspannungen beim Abheben des Siebes und/oder der Schablone ein Überstand 24.

Zur Unterstützung der Einbringung der Leitpaste 22 in die Durchgangsöffnungen 22 kann vorgesehen sein, von der Unterseite des Verbundes her, also von Seiten der Folie 18, eine Beaufschlagung mit Unterdruck vorzunehmen, so daß die Paste 22 in die Durchgangsöffnung 20 quasi eingesaugt wird. Hierdurch wird ein vollständiges Ausfüllen der Durchgangsöffnungen 20 erreicht. Insbesondere wenn ein Aspektverhältnis von einer axialen Länge der Durchgangsöffnung 20 zu deren Durchmesser sehr groß ist, wird ein vollständiges Auffüllen der Durchgangsöffnung 20 durch das Einsaugen der Paste 22 sichergestellt. Zum Aufbringen des Unterdruckes kann das Substrat 10 beispielsweise auf eine entsprechende Vorrichtung aufgebracht sein, die über geeignete Mittel das Beaufschlagen mit Unterdruck gestattet. Hierzu kann beispielsweise eine poröse Unterlage vorgesehen sein, die mit einem Vakuum beaufschlagt wird, so daß durch die poröse Unterlage hindurch der Unterdruck auf die Paste 22 wirkt und diese in die Durchgangsöffnung 20 hineinsaugt. Eine derartige Unterlage kann beispielsweise aus Sinterbronze bestehen. Um Verschmutzungen der Unterlage zu vermeiden, kann gegebenenfalls vorgesehen sein, zwischen Unterlage und dem Laminatverbund eine Schutzschicht, beispielsweise in Form eines porösen Papieres, einzubringen. Dieses schützt einerseits die Unterlage und gestattet andererseits das Beaufschlagen der Durchgangsöffnungen 20 mit Unterdruck.

In einem nächsten, in Figur 4 verdeutlichten Verfahrensschritt, wird der mit Paste 22 gefüllte Durchgangsöffnungen 20 aufweisende Verbund einer Trocknung unterzogen. Während der Trocknung verflüchtigen sich die in der eingefüllten Paste 22 vorhandenen Lösungsmittel, so daß diese einem Schwund unterliegen. Hierdurch ergeben sich die angedeuteten Vertiefungen 26 der Paste 22. Die Dicke der Folien 16 und 18 ist so gewählt, daß der zu erwartende Schwund, das heißt die Tiefe der Vertiefungen 26, geringer ist als die Dicke der Folien 16 und 18. Hierdurch wird sichergestellt, daß der Grund der Vertiefungen 26 jedenfalls oberhalb der Oberflächen des Substrates 10 liegt. Die aufgebrachten Hilfsfolien 16 und 18 dienen somit als Depot für die Leitpaste 22, indem die in den Folien 16 und 18 eingebrachten Teilabschnitte der Durchgangsöffnung 20 hilfsweise mit der Paste 22 gefüllt sind, jedoch das diesen Abschnitten entsprechende Volumen als Schwundvolumen zur Verfügung steht.

Wie Figur 5 verdeutlicht, wird in einem nächsten Verfahrensschritt die Hilfsfolie 16 und 18 entfernt, so daß das die Durchgangsöffnung 20 aufweisende Substrat als Rohling mit an den Oberflächen 28 beziehungsweise 30 überstehender Paste 22 zur Verfügung steht. Deutlich wird der auf beiden Seiten des Substrates 10 vorhandene Überstand 32 beziehungsweise 34 der Leitpaste 22, der als Depot für die weitere Bearbeitung zur Verfügung steht.

Durch einen weiteren Prozeßschritt kann der Pastenüberstand vor dem nachfolgenden Sinterprozeß unter Einwirkung von Druck und/oder Temperatur eingeebnet werden, wobei der Druck und/oder die Temperatur beispielsweise niedriger sind als beim Laminieren der Folie.

Nachfolgend wird das als grüne Folie vorliegende Substrat 10 einer Sinterung unterzogen. Hierbei kommt es zu einem Sinterschrumpfen sowohl des Substrates 10 als auch der Leitpaste 22. Entsprechend der eingestellten Sinterparameter und/oder der gewählten Materialien sowohl des Substrates 10 als auch der Paste 22 kann sich im Anschluß an das Sintern entweder, wie in Figur 6 gezeigt, eine Sintervertiefung 36 der Leitpaste 22 oder, wie Figur 7 zeigt, eine Sintererhöhung 38 der Leitpaste 22 ergeben. Im Idealfall sind die Materialien und Parameter so aufeinander abgestimmt, daß sich nach dem Sintern eine glatte Fläche sowohl an der Oberfläche 28 als auch an der Oberfläche 30 ergibt. Aufgrund bestehender Toleranzen wird sich jedoch eine Sintervertiefung 36 oder eine Sintererhöhung 38 einstellen. Soll mit Sicherheit eine glatte Oberfläche 28 beziehungsweise 30 erreicht werden, können die Parameter der Sinterung und die Materialien so gewählt werden, daß eine Sintererhöhung in jedem Fall verbleibt, die anschließend, beispielsweise durch Polieren oder Abstrahlen, abgetragen werden kann.

Das Sintern kann beispielsweise in einem Durchlauf- oder Kammerofen erfolgen. Die hierbei eingestellten Sintertemperaturen sind auf die Materialien des Substrates 10 und der Leitpaste 22 abgestimmt. So beträgt eine Sintergrenztemperatur bei einer silberhaltigen Leitpaste beispielsweise 850 bis 910°C, während bei einer goldhaltigen Leitpaste die Sintergrenztemperatur bei circa 910 bis 950°C liegt.

Zum Erzielen möglichst glatter Oberflächen 28 und 30 kann das Substrat 10 während des Sinterns mit einem Druck beaufschlagt werden, so daß die laterale Schrumpfung des Substrates 10 und der Leitpaste 22 druckabhängig einstellbar ist. Hierdurch wird erreicht, daß die Durchkontaktierungen druckdicht sintern.

Nach der Sinterung erhält man ein Substrat 10, dessen Durchgangsöffnungen 20 mit einer Leitpaste 22 gefüllt sind. Die Leitpaste 22 dient einerseits der elektrischen Kontaktierung von auf der Oberfläche 28 beziehungsweise 30 angeordneter Bauelemente und gewährleistet andererseits eine hermetische Abdichtung der Oberfläche 28 zur Oberfläche 29 (bei entsprechender Anordnung des Substrates 10). Durch die einfach zu beherrschenden Verfahrensschritte, wie Stanzen, Drucken und Sintern, können die druckdichten Durchkontaktierungen in einfacher Weise kostengünstig in Massenfertigung erzielt werden.

## Patentansprüche

1. Verfahren zur Herstellung druckdichter Durchkontaktierungen in Substraten, insbesondere in keramischen Dünnschichten, wobei die Durchkontaktierungen in das Substrat nachträglich eingebracht werden, indem das Substrat mit Durchgangsöffnungen versehen wird, **dadurch gekennzeichnet**, daß die Durchgangsöffnungen (20) mit einer elektrisch leitfähigen Paste (22) vollständig gefüllt werden, und die Paste (22) anschließend dicht ausgehärtet wird.

2. Verfahren nach Anspruch 1, **dadurch gekennzeichnet**, daß die Durchgangsöffnungen (20) in ein als grüne Folie vorliegendes Substrat (10) eingebracht wird, die Durchgangsöffnungen (20) mit der Leitpaste (22) gefüllt werden, und das Substrat (10) mit der Leitpaste (22) gemeinsam gesintert wird.

3. Verfahren nach einem der vorhergehenden Ansprüche, **dadurch gekennzeichnet**, daß das Substrat (10) mit der Leitpaste (22) gemeinsam unter Druck gesintert wird, wobei die laterale Schrumpfung von dem Substrat (10) und der Leitpaste (22) so aufeinander abgestimmt ist, daß die Durchkontaktierung druckdicht sintert.

4. Verfahren nach einem der vorhergehenden Ansprüche, **dadurch gekennzeichnet**, daß das als grüne Folie vorliegende Substrat (10) wenigstens an einer Seite mit einer Hilfsfolie (16, 18) versehen wird, und die die Durchkontaktierungen ergebenden Durchgangsöffnungen (20) durch das Substrat (10) und die Hilfsfolien (16, 18) eingebracht werden, und die der Dicke der Hilfsfolien (16, 18) entsprechenden Abschnitte der Durchgangsöffnungen (20) ebenfalls mit der Leitpaste (22) gefüllt werden.

5. Verfahren nach einem der vorhergehenden Ansprüche, **dadurch gekennzeichnet**, daß die Dicke der Hilfsfolien (16, 18) so gewählt ist, daß ein Materialdepot derart erreicht wird, daß vorhandene Unterschiede im Sinterschrumpf zwischen Substratmaterial und Durchkontaktierung ausgeglichen werden und eine druckdichte Durchkontaktierung entsteht.

6. Verfahren nach einem der vorhergehenden Ansprüche, **dadurch gekennzeichnet**, daß die Leitpaste (22) in die Durchgangsöffnungen (20) durch Drucken eingebracht wird.

7. Verfahren nach Anspruch 6, **dadurch gekennzeichnet**, daß die Leitpaste (22) mittels Siebdruck eingebracht wird.

8. Verfahren nach Anspruch 6, **dadurch gekennzeichnet**, daß die Leitpaste (22) durch Schablonendruck eingebracht wird.

9. Verfahren nach einem der vorhergehenden Ansprüche, **dadurch gekennzeichnet**, daß die Leitpaste (22) in die Durchgangsöffnungen (20) eingesaugt wird.

10. Verfahren nach einem der vorhergehenden Ansprüche, **dadurch gekennzeichnet**, daß das Substrat (10) gemeinsam mit der in die Durchgangsöffnung (20) eingebrachten Leitpaste (22) gesintert wird.

11. Verfahren nach einem der vorhergehenden Ansprüche, **dadurch gekennzeichnet**, daß vor dem Sintern die Hilfsfolien (16, 18) entfernt werden.

12. Verfahren nach einem der vorhergehenden Ansprüche, **dadurch gekennzeichnet**, daß eine Sintertemperatur auf eine Sintergrenztemperatur der Leitpaste (22) abgestimmt wird.

13. Verfahren nach einem der vorhergehenden Ansprüche, **dadurch gekennzeichnet**, daß ein Pastenüberstand der Durchkontaktierungspaste (22) vor dem Sintern des Substrates (10) unter Druck und/oder Temperatur eingeebnet wird.

14. Verfahren nach Anspruch 13, **dadurch gekennzeichnet**, daß Druck und/oder Temperatur niedriger gewählt werden als beim Lnainieren der Folien (10, 12).
